# EUROPEAN PATENT APPLICATION

(11) **EP 4 513 533 A1**
(43) Date of publication of application: **26.02.2025**
(21) Application number: 24194555.9
(22) Date of filing: 14.08.2024
(51) Int. Cl.: H01L 21/56, H01L 23/552, H01L 21/60, H01L 23/31, H01L 23/495

(54) **SEMICONDUCTOR DEVICE WITH EMBEDDED LEADFRAME AND METHOD THEREFOR**

(30) Priority: 22.08.2023 US 202318236481
(71) Applicant: NXP B.V., 5656 AG Eindhoven (NL)
(72) Inventor: Mao, Kuan-Hsiang, 5656AG Eindhoven (NL); Siong, Chin Teck, 5656AG Eindhoven (NL); Hiew, Pey Fang, 5656AG Eindhoven (NL); Huang, Wen Hung, 5656AG Eindhoven (NL)
(74) Representative: Hardingham, Christopher Mark

(57) **Abstract**

A method of forming a semiconductor device is provided. The method includes forming a redistribution layer (RDL) substrate (302) over an active side of a semiconductor die (102). The RDL substrate includes a plurality of under-bump metallization (UBM) structures (306). A die pad (504) of a leadframe (502) is affixed on a backside of the semiconductor die. The leadframe includes a plurality of leads (506) having a first portion of each lead connected to the die pad and a second portion of each lead extending vertically along sidewalls of the semiconductor die toward a plane of the RDL substrate. An encapsulant (602) encapsulates the semiconductor die and the leadframe, a lead tip portion of each lead is exposed through the encapsulant.

## Description

### Background

### Field

This disclosure relates generally to semiconductor device packaging, and more specifically, to semiconductor devices with embedded leadframe and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified bottom-side-up plan view, an example semiconductor device having an embedded leadframe at a stage of manufacture in accordance with an embodiment.
FIG. 2 through FIG. 4 illustrate, in simplified cross-sectional views, the example semiconductor device at stages of manufacture in accordance with an embodiment.
FIG. 5A and FIG. 5B illustrate, in simplified cross-sectional and plan views, the example semiconductor device at a stage of manufacture in accordance with an embodiment.
FIG. 6 through FIG. 9 illustrate, in simplified cross-sectional views, the example semiconductor device at subsequent stages of manufacture in accordance with an embodiment.

### Detailed Description

Generally, there is provided, a semiconductor device having an embedded leadframe. The semiconductor device includes a semiconductor die, a redistribution layer substrate formed on the active side of the semiconductor die, and a leadframe attached to the backside of the semiconductor die. The redistribution layer substrate may be formed as a build-up substrate or may be provided as a pre-formed substrate. Conductive connectors such as solder balls are affixed to under-bump metallization structures of the redistribution layer substrate. The conductive connectors are interconnected to the bond pads of the semiconductor die by way of the redistribution layer substrate, for example. The leadframe includes a die pad and a plurality of leads connected to the die pad. The leadframe is pre-formed such that the plurality of leads extend vertically from the die pad and surround the sidewalls of the semiconductor die in a cage-like manner. The semiconductor die and the leadframe are encapsulated with an encapsulant. Each lead of the plurality of lead includes a lead tip region exposed through the bottom side of the encapsulant. Likewise, the bottom side of the redistribution layer substrate including the conductive connectors attached to the under-bump metallization structures are exposed through the bottom side of the encapsulant. The exposed lead tip regions and the conductive connectors are configured for attachment to a printed circuit board, for example. By forming the semiconductor device with the embedded leadframe in this manner, additional package strength and secure mechanical bonding of the semiconductor device is achieved when the exposed lead tip regions of the leadframe are mounted on a printed circuit board, thus improving board level reliability. In addition, the embedded leadframe may be configured to serve as an electromagnetic interference shield and/or a heat spreader allowing greater flexibility.

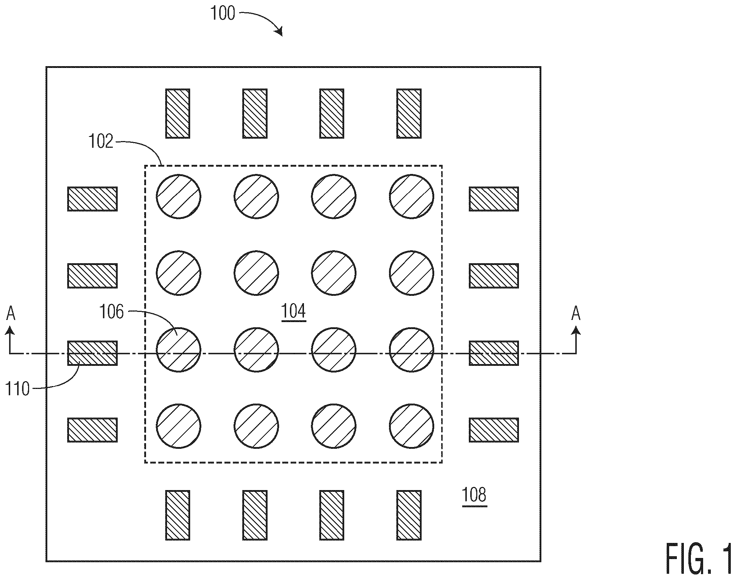

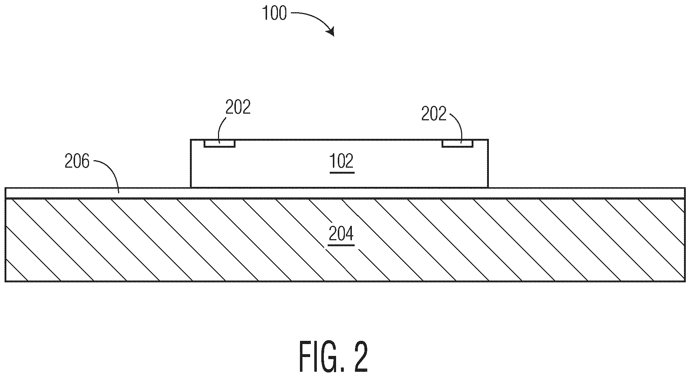

FIG. 1 illustrates, in a simplified bottom-side-up plan view, an example semiconductor device 100 having an embedded leadframe at a stage of manufacture in accordance with an embodiment. At this stage, the semiconductor device 100 includes a semiconductor die 102 (shown as dashed outline for reference) and a package leadframe embedded in an encapsulant 108, a package substrate 104 formed over the semiconductor die 102, a plurality of conductive connectors 106 (e.g., solder balls) affixed to the bottom side of the package substrate 104, and a plurality of lead tips 110 of the package leadframe exposed through the encapsulant 108. In this embodiment, the semiconductor device 100 may be characterized as having a hybrid package connectivity scheme with the plurality of conductive connectors 106 in a BGA-type arrangement surrounded by the plurality of lead tips 110 of a QFP-type leadframe. The number and arrangement of the conductive connectors 106 and the leadframe lead tips 110 in this embodiment are chosen for illustration purposes. The term "conductive," as used herein, generally refers to electrical conductivity unless otherwise described. Simplified cross-sectional views of the example semiconductor device 100 taken along line A-A at stages of manufacture are depicted in FIG. 2 through FIG. 8.

FIG. 2 illustrates, in a simplified cross-sectional view, the example semiconductor device 100 taken along line A-A at a stage of manufacture in accordance with an embodiment. At this stage, the semiconductor device 100 includes the semiconductor die 102 placed on a carrier substrate 204. The carrier substrate 204 includes a releasable adhesive 206 applied on a top surface. The carrier substrate 204 is configured and arranged to provide a temporary structure for placement of the semiconductor die 102 during formation of a redistribution layer (RDL) substrate at a subsequent stage of manufacture, for example.

The semiconductor die 102 has an active side (e.g., major side having circuitry) and a backside (e.g., major side opposite of the active side). The semiconductor die 102 includes bond pads 202 formed at the active side. In this embodiment, semiconductor die 102 is oriented with the active side up having the backside temporarily affixed on the carrier substrate 204. The semiconductor die 102 may be formed from any suitable semiconductor material, such as silicon, germanium, gallium arsenide, gallium nitride, and the like. The semiconductor die 102 further includes any digital circuits, analog circuits, RF circuits, power circuits, memory, processor, the like, and combinations thereof formed at the active side.

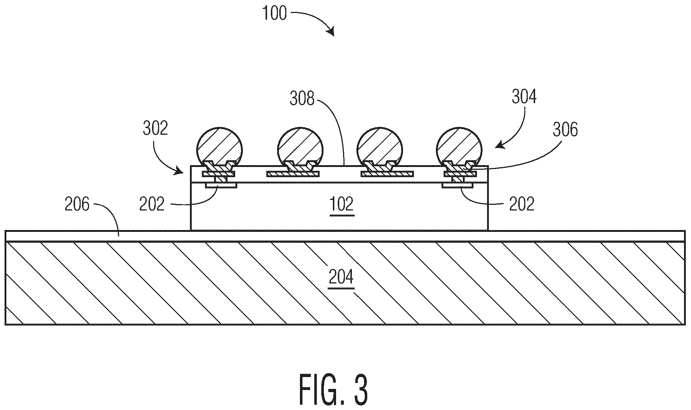

FIG. 3 illustrates, in a simplified bottom-side-up cross-sectional view, the example semiconductor device 100 at a subsequent stage of manufacture in accordance with an embodiment. At this stage, an RDL substrate 302 is applied to the active side of the semiconductor die 102. The RDL substrate 302 includes conductive features such as traces, vias, and under-bump metallization (UBM) structures 306 surrounded by non-conductive material (e.g., dielectric). In this embodiment, the conductive traces are formed from patterned metal (e.g., copper) layers separated by dielectric layers of the RDL substrate 302. The traces and UBM structures 306 are formed in the RDL substrate 302 to interconnect the semiconductor die 102 with a printed circuit board (PCB), for example. The RDL substrate 302 may be formed as a build-up substrate directly on the active side of the semiconductor die 102 or may be provided as a pre-formed substrate otherwise applied on the active side of the semiconductor die 102.

In this embodiment, conductive connectors 304 (e.g., solder balls) are affixed to respective UBM structures 306 exposed at the bottom side 308 of the RDL substrate 302. The conductive connectors 304 may be in the form of suitable conductive structures such as solder balls, gold studs, copper pillars, and the like, to connect conductive features of the semiconductor device 100 with the PCB.

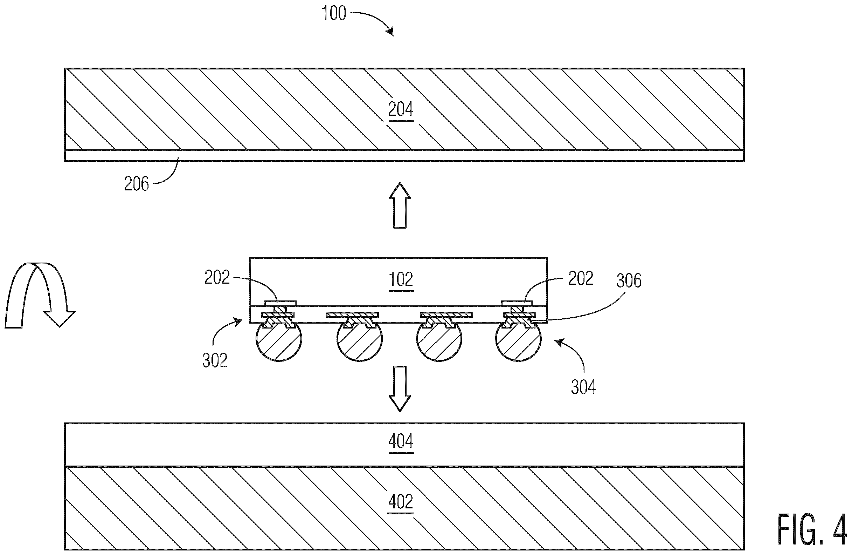

FIG. 4 illustrates, in a simplified cross-sectional view, the example semiconductor device 100 at a subsequent stage of manufacture in accordance with an embodiment. At this stage, the semiconductor device 100 is separated from the carrier substrate 204, reoriented (e.g., flipped), and placed on a second carrier substrate 402. The carrier substrate 402 includes a thicker releasable adhesive 404 applied on a top surface. The thick releasable adhesive 404 is chosen to accommodate the conductive connectors 304 of the semiconductor device 100. The carrier substrate 402 is configured and arranged to provide a temporary structure for placement of the semiconductor device 100 during subsequent stages of manufacture, for example. In this embodiment, the semiconductor device 100, including the semiconductor die 102 and RDL substrate 302 with attached conductive connectors 304, is placed onto the carrier substrate 402 such that the conductive connectors 304 are substantially embedded in the releasable adhesive 404.

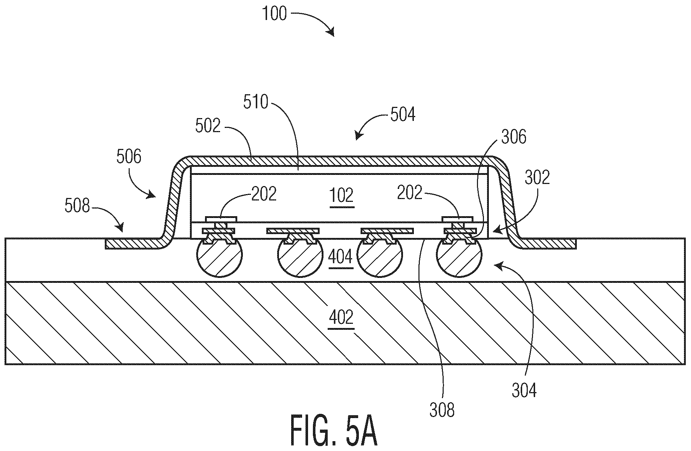

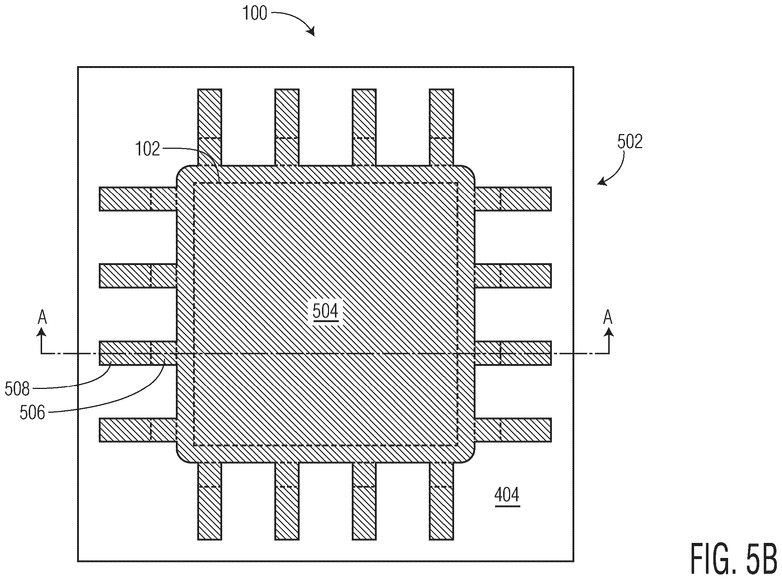

FIG. 5A and FIG. 5B illustrate, in simplified cross-sectional and plan views, the example semiconductor device 100 at a subsequent stage of manufacture in accordance with an embodiment. For example, FIG. 5A depicts a cross-sectional view and FIG. 5B depicts a top-side-up plan view of the semiconductor device 100 with the corresponding section line A-A shown for reference. At this stage, the semiconductor device 100 includes a leadframe 502 affixed on the back side of the semiconductor die 102. The leadframe 502 includes a die pad 504 and a plurality of leads 506. The die pad 504 portion of the leadframe 502 is configured for attachment to the semiconductor die 102 by way of a die attach adhesive 510 such as a die attach film (DAF). In this embodiment, the die attach adhesive 510 may be characterized as a conductive die attach material.

The leadframe 502 may be formed from any suitable electrically conductive metal material, such as copper, silver, nickel, aluminum, or iron, or alloys thereof, for example. The conductive metal may be bare, partially plated, or plated with another metal or alloy such thereof. In this embodiment, the die pad 504 and the plurality of leads 506 of the leadframe 502 are formed from a common metal sheet. In some embodiments, the leadframe 502 may include being used for thermal conduction as well as electrical conduction. The number and arrangement of leads 506 of the leadframe 502 are chosen for illustration purposes.

Each lead 506 of the plurality of leads has a proximal end portion directly connected to the die pad 504 and a distal end (e.g., lead tip) portion 508 placed on the carrier substrate 402. In this embodiment, the leads 506 are pre-formed (e.g., bent) to extend vertically downward along sidewalls of the semiconductor die toward a plane in common with the bottom side 308 of the RDL substrate 302. The distal end portion of each lead 506 is configured to form the lead tip portion 508 substantially coplanar with the UBM structures 306 of the RDL substrate 302. In this embodiment, the conductive connectors 304 affixed to the UBM structures 306 and the lead tip portions 508 of the plurality of leads 506 are substantially embedded in the releasable adhesive 404 when the semiconductor device 100 is placed on the carrier substrate 402.

In this embodiment, the leadframe 502 is configured to form a cage-like structure having die pad 504 covering the backside of the semiconductor die 102 and the plurality of leads 506 substantially surrounding the semiconductor die 102 on all four sides. In some embodiments, the cage-like structure of the leadframe 502 surrounding the semiconductor die 102 may be further configured to serve as an EMI shield. In some embodiments, the leadframe 502 may be attached to the backside of the semiconductor die 102 by way of a thermally conductive die attach adhesive 510 and further configured to serve as a heat spreader.

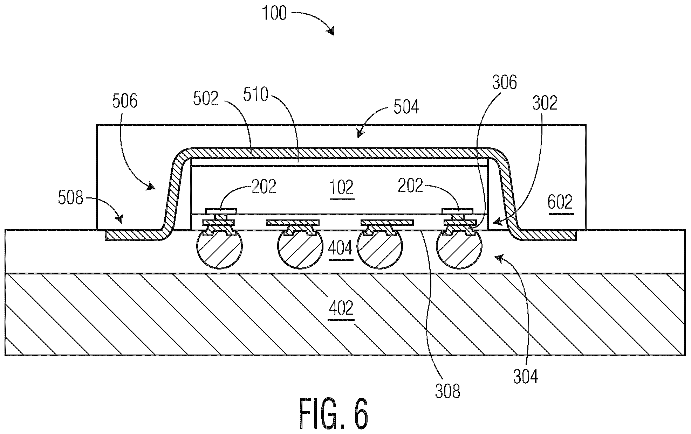

FIG. 6 illustrates, in a simplified cross-sectional view, the example semiconductor device 100 at a subsequent stage of manufacture in accordance with an embodiment. At this stage, the semiconductor device 100 includes the semiconductor die 102 and the leadframe 502 at least partially encapsulated with an encapsulant 602 while temporarily affixed on the carrier substrate 402. In this embodiment, the semiconductor die 102 and the leadframe 502 are over-molded with the encapsulant 602 (e.g., epoxy molding compound) by way of an injection molding or transfer molding process, for example. In some embodiments, the semiconductor die 102 and the leadframe 502 may be encapsulated with the encapsulant 602 by way of a film-assisted molding (FAM) process. For example, a FAM tool using a conformal film may be engaged with predetermined portions of the conductive connectors 304 and the lead tip portions 508 during the molding process to keep the predetermined portions free from encapsulant.

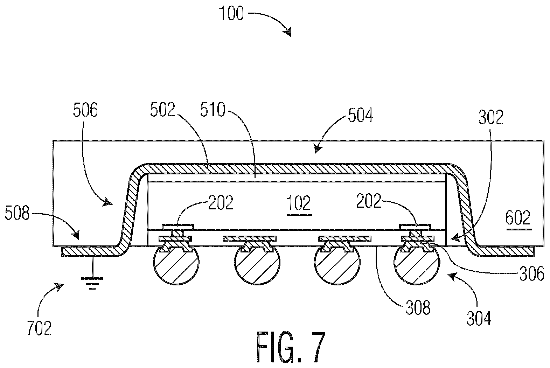

FIG. 7 illustrates, in a simplified cross-sectional view, the example semiconductor device 100 at a subsequent stage of manufacture in accordance with an embodiment. At this stage, the encapsulated semiconductor device 100 is separated from the carrier substrate 402. In this embodiment, portions of the bottom side 308 of the RDL substrate 302, portions of the conductive connectors 304, and the lead tip portions 508 of the leadframe 502 are revealed at a bottom side of the encapsulated semiconductor device 100 when the carrier substrate 402 is removed. After the carrier substrate 402 is removed, the exposed portions of the conductive connectors 304 and the lead tips 508 may be conductively affixed to a printed circuit board (PCB). For example, the conductive connectors 304 may be connected to the PCB to provide input and/or output signal and power supply connectivity between the semiconductor die 102 and the PCB, and the lead tips 508 may be connected to the PCB to provide a ground connection 702 to the leadframe 502. In addition, by affixing the lead tips 508 of the leadframe 502 to the PCB, a more secure and structurally sound connection is formed between the semiconductor device 100 and the PCB.

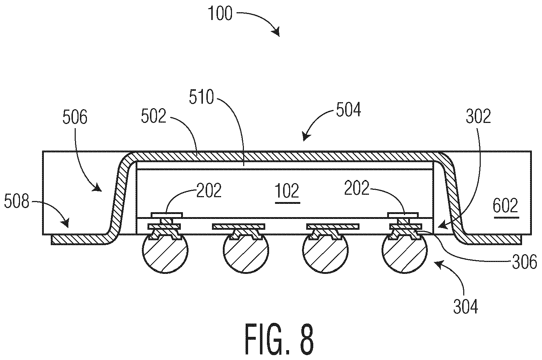

FIG. 8 illustrates, in a simplified cross-sectional view, the example semiconductor device 100 at a subsequent stage of manufacture in accordance with an embodiment. At this stage, a back side of the die pad 504 is revealed a top side of the encapsulated semiconductor device 100. In this embodiment, the top side of the encapsulated semiconductor device 100 is subjected to a grind operation to expose the back side of the die pad 504 through the encapsulant. By having the back side of the die pad 504 of the leadframe 502 exposed, an external heatsink may be affixed to the die pad 504 when configured as a heat spreader. After exposing the back side of the die pad 504 through the encapsulant, the semiconductor device may be affixed to the PRB by way of the conductive connectors 304 and the lead tips 508.

Generally, there is provided, a method including forming a redistribution layer (RDL) substrate over an active side of a semiconductor die, the RDL substrate having a plurality of under-bump metallization (UBM) structures; affixing a die pad of a leadframe on a backside of the semiconductor die, the leadframe including a plurality of leads having a first portion of each lead connected to the die pad and a second portion of each lead extending vertically along sidewalls of the semiconductor die toward a plane of the RDL substrate; and encapsulating with an encapsulant the semiconductor die and the leadframe, a lead tip portion of each lead exposed through the encapsulant. The plurality of leads of the leadframe may be pre-bent such that the plurality of leads substantially surround the sidewalls of the semiconductor die after affixing the die pad on the backside of the semiconductor die. A lead tip portion of each lead the plurality of leads may be substantially coplanar with the UBM structures of the RDL substrate. The plurality of leads and the die pad of the leadframe may be formed from a same contiguous metal. The method may further include affixing a plurality of conductive ball connectors to respective UBM structures. The lead tip regions of the plurality of leads may be configured for connection to a printed circuit board. The leadframe may be configured as electromagnetic interference (EMI) shield. The method may further include grinding a top surface of the encapsulant to expose a backside of the die pad of the leadframe. The exposed die pad of the leadframe may be configured for attachment of a heat sink or heat spreader.

In another embodiment, there is provided, a semiconductor device including a semiconductor die having a plurality of bond pads located at an active side of the semiconductor die; a redistribution layer (RDL) substrate formed over the active side of the semiconductor die, the RDL substrate having a plurality of under-bump metallization (UBM) structures configured for attachment of ball connectors; a die pad of a leadframe affixed on a backside of the semiconductor die, the leadframe including a plurality of leads connected to the die pad and bent such that the leads extend vertically from the die pad toward a plane of the RDL substrate; and an encapsulant encapsulating the semiconductor die and at least a portion of the leadframe, a lead tip portion of each lead of the plurality of leads exposed through the encapsulant. The lead tip portion of each lead of the plurality of leads may be substantially coplanar with the plurality of UBM structures. The plurality of leads of the leadframe may be bent and extend vertically such that the plurality of leads substantially surround the sidewalls of the semiconductor die. The semiconductor device may further include a plurality of conductive ball connectors affixed to respective UBM structures. A backside of the die pad of the leadframe may be exposed through a top surface of the encapsulant. The exposed backside of the die pad of the leadframe may be configured for attachment of a heat sink or heat spreader.

In yet another embodiment, there is provided, a method including forming a redistribution layer (RDL) substrate over an active side of a semiconductor die, the RDL substrate having a plurality of under-bump metallization (UBM) structures; affixing a die pad of a leadframe on a backside of the semiconductor die, the leadframe including a plurality of leads having a first portion of each lead connected to the die pad and a second portion of each lead extending vertically along sidewalls of the semiconductor die to a lead tip portion; and encapsulating with an encapsulant the semiconductor die and the leadframe, the lead tip portion of each lead exposed through the encapsulant. The lead tip portion of each lead exposed through the encapsulant may be substantially coplanar with the plurality of UBM structures of the RDL substrate. The plurality of leads of the leadframe may be pre-bent such that the plurality of leads are distributed around the sidewalls of the semiconductor die after affixing the die pad on the backside of the semiconductor die. The method may further include exposing a backside of the die pad of the leadframe through the encapsulant. The plurality of leads and the die pad of the leadframe may be formed from a same contiguous metal.

By now, it should be appreciated that there has been provided a semiconductor device having an embedded leadframe. The semiconductor device includes a semiconductor die, a redistribution layer substrate formed on the active side of the semiconductor die, and a leadframe attached to the backside of the semiconductor die. The redistribution layer substrate may be formed as a build-up substrate or may be provided as a pre-formed substrate. Conductive connectors such as solder balls are affixed to under-bump metallization structures of the redistribution layer substrate. The conductive connectors are interconnected to the bond pads of the semiconductor die by way of the redistribution layer substrate, for example. The leadframe includes a die pad and a plurality of leads connected to the die pad. The leadframe is pre-formed such that the plurality of leads extend vertically from the die pad and surround the sidewalls of the semiconductor die in a cage-like manner. The semiconductor die and the leadframe are encapsulated with an encapsulant. Each lead of the plurality of lead includes a lead tip region exposed through the bottom side of the encapsulant. Likewise, the bottom side of the redistribution layer substrate including the conductive connectors attached to the under-bump metallization structures are exposed through the bottom side of the encapsulant. The exposed lead tip regions and the conductive connectors are configured for attachment to a printed circuit board, for example. By forming the semiconductor device with the embedded leadframe in this manner, additional package strength and secure mechanical bonding of the semiconductor device is achieved when the exposed lead tip regions of the leadframe are mounted on a printed circuit board, thus improving board level reliability. In addition, the embedded leadframe may be configured to serve as an electromagnetic interference shield and/or a heat spreader allowing greater flexibility.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method of comprising:
forming a redistribution layer, RDL, substrate over an active side of a semiconductor die, the RDL substrate having a plurality of under-bump metallization (UBM) structures;
affixing a die pad of a leadframe on a backside of the semiconductor die, the leadframe including a plurality of leads having a first portion of each lead connected to the die pad and a second portion of each lead extending vertically along sidewalls of the semiconductor die toward a plane of the RDL substrate; and
encapsulating with an encapsulant the semiconductor die and the leadframe, a lead tip portion of each lead exposed through the encapsulant.

2. The method of claim 1, wherein the plurality of leads of the leadframe are pre-bent such that the plurality of leads substantially surround the sidewalls of the semiconductor die after affixing the die pad on the backside of the semiconductor die.

3. The method of any preceding claim, wherein a lead tip portion of each lead the plurality of leads are substantially coplanar with the UBM structures of the RDL substrate.

4. The method of any preceding claim, wherein the plurality of leads and the die pad of the leadframe are formed from a same contiguous metal.

5. The method of any preceding claim, further comprising affixing a plurality of conductive ball connectors to respective UBM structures.

6. The method of any preceding claim, wherein the lead tip regions of the plurality of leads are configured for connection to a printed circuit board.

7. The method of any preceding claim, wherein the leadframe is configured as electromagnetic interference, EMI, shield.

8. The method of any preceding claim 1, further comprising grinding a top surface of the encapsulant to expose a backside of the die pad of the leadframe.

9. The method of claim 7, wherein the exposed die pad of the leadframe is configured for attachment of a heat sink or heat spreader.

10. A semiconductor device comprising:
a semiconductor die having a plurality of bond pads located at an active side of the semiconductor die;
a redistribution layer, RDL, substrate formed over the active side of the semiconductor die, the RDL substrate having a plurality of under-bump metallization, UBM, structures configured for attachment of ball connectors;
a die pad of a leadframe affixed on a backside of the semiconductor die, the leadframe including a plurality of leads connected to the die pad and bent such that the leads extend vertically from the die pad toward a plane of the RDL substrate; and
an encapsulant encapsulating the semiconductor die and at least a portion of the leadframe, a lead tip portion of each lead of the plurality of leads exposed through the encapsulant.

11. The semiconductor device of claim 10, wherein the lead tip portion of each lead of the plurality of leads is substantially coplanar with the plurality of UBM structures.

12. The semiconductor device of claim 10 or 11, wherein the plurality of leads of the leadframe are bent and extend vertically such that the plurality of leads substantially surround the sidewalls of the semiconductor die.

13. The semiconductor device of any of claims 10 to 12, further comprising a plurality of conductive ball connectors affixed to respective UBM structures.

14. The semiconductor device of any of claims 10 to 13, wherein a backside of the die pad of the leadframe is exposed through a top surface of the encapsulant.

15. The semiconductor device of claim 14, wherein the exposed backside of the die pad of the leadframe is configured for attachment of a heat sink or heat spreader.
